(19) Europäisches Patentamt
European Patent Office
Office européen des brevets

(11) **EP 4 748 629 A1**

(12) **EUROPEAN PATENT APPLICATION**
published in accordance with Art. 153(4) EPC

(43) Date of publication:
**27.05.2026 Bulletin 2026/22**

(21) Application number: **24863000.6**

(22) Date of filing: **12.07.2024**

(51) International Patent Classification (IPC):
*B60L 53/60* (2019.01)          *B60L 53/80* (2019.01)
*B60L 53/53* (2019.01)          *B60L 3/12* (2006.01)
*H02J 7/34* (2006.01)          *H02J 7/00* (2026.01)
*H02J 7/14* (2006.01)

(52) Cooperative Patent Classification (CPC):
**B60L 58/18; B60L 53/80; B60L 58/12; B60L 58/16;
G01R 31/387; G01R 31/392**

(86) International application number:
**PCT/KR2024/010059**

(87) International publication number:
**WO 2025/053417 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.09.2023  KR 20230117274
04.07.2024  KR 20240088443**

(71) Applicant: **LG Energy Solution, Ltd.
Seoul 07335 (KR)**

(72) Inventors:
• **LEE, Dong Yeol
Daejeon 34122 (KR)**
• **IN, Se Hwan
Daejeon 34122 (KR)**

(74) Representative: **Plasseraud IP
104 Rue de Richelieu
CS92104
75080 Paris Cedex 02 (FR)**

(54) **ESS MANAGEMENT DEVICE, ESS MANAGEMENT METHOD, AND ESS MANAGEMENT SYSTEM**

(57)     An ESS management apparatus disclosed herein includes: a memory; and a processor operatively connected to the memory. The processor is configured to: acquire vehicle usage data from a first battery pack used in a vehicle among multiple battery packs of an energy storage system (ESS); acquire charging state data of remaining battery packs excluding the first battery pack among the multiple battery packs; and select a second battery pack to replace the first battery pack from among the remaining battery packs based on the vehicle usage data and the charging state data.

FIG.2

**Description**

**TECHNICAL FIELD**

CROSS REFERENCE TO RELATED APPLICATION

This application is based on and claims priority to Korean Patent Application No. 10-2023-0117274 filed on September 4, 2023 and Korean Patent Application No. 10-2024-0088443 filed on July 4, 2024 with the Korean Intellectual Property Office, the entire disclosures of all these applications being incorporated by reference herein into the present application.

TECHNICAL FIELD

Embodiments disclosed herein relate to an energy storage system (ESS) management apparatus, an ESS management method, and an ESS management system.

**BACKGROUND ART**

Research and development on secondary batteries has recently been actively conducted. Secondary batteries, which are rechargeable batteries, may be interpreted as encompassing both conventional batteries, such as Ni/Cd batteries and Ni/MH batteries, and recent lithium ion batteries. Among the secondary batteries, lithium-ion batteries may have a higher energy density than, for example, conventional Ni/Cd batteries and Ni/MH batteries, and may be manufactured to be small and lightweight, providing high versatility as power sources for mobile devices. The lithium-ion batteries have recently expanded their uses to power sources for electric vehicles, gaining attention as a next-generation energy storage medium.

**DISCLOSURE**

**TECHNICAL PROBLEM**

The embodiments disclosed herein provide an energy storage system (ESS) management apparatus, an ESS management method, and an ESS management system, all of which enable the utilization of power from an energy storage system in an electric vehicle.

The embodiments disclosed herein are not limited to the above-mentioned technical problems, and other technical problems not mentioned above will be clearly understood by those skilled in the art from the following descriptions.

**TECHNICAL SOLUTION**

According to some embodiments disclosed herein, an ESS management apparatus includes a memory, and a processor, which is operatively connected to the memory. The processor is configured to: acquire vehicle usage data from a first battery pack used in a vehicle among multiple battery packs of an energy storage system (ESS); acquire charging state data of remaining battery packs excluding the first battery pack among the multiple battery packs; and select a second battery pack to replace the first battery pack from among the remaining battery packs based on the vehicle usage data and the charging state data.

According to some embodiments, the processor is configured to: form a communication channel with a first pack management apparatus of the first battery pack when entry into a replacement mode of the first battery pack is detected; and acquire the vehicle usage data from the first pack management apparatus through the communication channel.

According to some embodiments, the processor is configured to enter the replacement mode when a battery replacement button, provided to remove the first battery pack from the vehicle, is pressed by a user, or the first battery pack is separated from the vehicle.

According to some embodiments, the vehicle usage data includes auxiliary usage data regarding an amount of power used by the first battery pack for auxiliary functions other than a driving function of the vehicle, and acceleration data regarding an impact event of the first battery pack in the vehicle, and the auxiliary functions include an air conditioning function for the interior of the vehicle, and the air conditioning function includes a cooling function, a heating function, a ventilation function, and a dehumidification function.

According to some embodiments, the processor is further configured to: display a location where the second battery pack is accommodated in the ESS on the display to inform the user of the location; and diagnose whether there is an abnormality in the first battery pack based on the acceleration data after the first battery pack is returned to the ESS.

According to some embodiments, the processor is configured to: calculate a first average power amount supplied to the vehicle on average by the multiple battery packs based on cumulative data of the auxiliary usage data of the first battery pack used in the vehicle; and select the second battery pack based on the first average power amount and a second average power amount supplied to an installation site of the ESS on average by the multiple battery packs.

According to some embodiments, the processor is configured to: calculate recommendation scores for the remaining battery packs based on states of health thereof, the first average power amount, and the second average power amount; and select the second battery pack from among the remaining battery packs based on the recommendation scores.

According to some embodiments, the processor is configured to: calculate a first suitability score, which indicates how suitable each of the remaining battery packs is for use in the vehicle, based on the remaining charge amounts of the remaining battery packs and the first average power amount; calculate a second suitability score, which indicates how suitable each of the remaining battery packs is for use at the installation site of the ESS, based on the remaining charge amounts of the remaining battery packs and the second average power amount; and calculate a recommendation score for each of the remaining battery packs based on the state of health, the first suitability score, and the second suitability score of each of the remaining battery packs.

According to some embodiments disclosed herein, an ESS management method includes: acquiring vehicle usage data from a first battery pack used in a vehicle among multiple battery packs of an energy storage system (ESS); acquiring charging state data of remaining battery packs excluding the first battery pack among the multiple battery packs; and selecting a second battery pack to replace the first battery pack from among the remaining battery packs based on the vehicle usage data and the charging state data.

According to some embodiments, the acquiring the vehicle usage data includes: forming a communication channel with a first pack management apparatus of the first battery pack when entry into a replacement mode of the first battery pack is detected; and acquiring the vehicle usage data from the first pack management apparatus through the communication channel.

According to some embodiments, the forming the communication channel includes entering the replacement mode when a battery replacement button provided to remove the first battery pack from the vehicle is pressed by a user or the first battery pack is separated from the vehicle.

According to some embodiments, the vehicle usage data includes auxiliary usage data regarding an amount of power used by the first battery pack for auxiliary functions other than a driving function of the vehicle, and acceleration data regarding an impact event of the first battery pack in the vehicle, and the auxiliary functions include an air conditioning function for an interior of the vehicle, and the air conditioning function includes a cooling function, a heating function, a ventilation function, and a dehumidification function.

According to some embodiments, the ESS management method further includes: displaying a location where the second battery pack is accommodated in the ESS on the display to inform the user of the location; and diagnosing whether there is an abnormality in the first battery pack based on the acceleration data after the first battery pack is returned to the ESS.

According to some embodiments, the selecting the second battery pack includes: calculating a first average power amount supplied to the vehicle on average by the multiple battery packs based on cumulative data of the auxiliary usage data of the first battery pack in the vehicle; and selecting the second battery pack based on the first average power amount and a second average power amount supplied to an installation site of the ESS on average by the multiple battery packs.

According to some embodiments, the selecting the second battery pack includes: calculating recommendation scores for the remaining battery packs based on states of health thereof, the first average power amount, and the second average power amount; and selecting the second battery pack based on the recommendation scores.

According to some embodiments, the calculating the recommendation scores includes: calculating a first suitability score, which indicates how suitable each of the remaining battery packs is for use in the vehicle, based on the remaining charge amounts of the remaining battery packs and the first average power amount; calculate a second suitability score, which indicates how suitable each of the remaining battery packs is for use at the installation site of the ESS, based on the remaining charge amounts of the remaining battery packs and the second average power amount; and calculating a recommendation score for each of the remaining battery packs based on the state of health, the first suitability score, and the second suitability score of each of the remaining battery packs.

According to some embodiments disclosed herein, an ESS management system includes multiple battery packs in an energy storage system (ESS), and an ESS management apparatus. The ESS management apparatus is configured to: acquire vehicle usage data from a first battery pack used in the vehicle among the multiple battery packs; acquire charging state data of remaining battery packs excluding the first battery pack among the multiple battery packs; and select a second battery pack to replace the first battery pack from among the remaining battery packs based on the vehicle usage data and the charging state data.

According to some embodiments, the ESS management apparatus is configured to: form a communication channel with a first pack management apparatus of the first battery pack when entry into a replacement mode of the first battery pack is detected; and acquire the vehicle usage data from the first pack management apparatus through the communication channel.

According to some embodiments, the ESS management apparatus is configured to enter the replacement mode when a battery replacement button provided to remove the first battery pack from the vehicle is pressed by a user or the first battery pack is separated from the vehicle.

According to some embodiments, the vehicle usage data includes auxiliary usage data regarding an amount of power used for auxiliary functions other than a driving function of the vehicle and acceleration data regarding an impact event of the vehicle, and the auxiliary functions include an air conditioning function for an interior of the vehicle, and the air conditioning function includes a cooling function, a heating function, a ventilation function, and a dehumidification function.

According to some embodiments, the ESS management apparatus is configured to: display a location where the second battery pack is accommodated in the ESS on the display to inform the user of the location; and diagnose whether there is an abnormality in the first battery pack based on the acceleration data after the first battery pack is returned to the ESS.

According to some embodiments, the ESS management apparatus is configured to: calculate a first average power amount supplied to the vehicle on average by the multiple battery packs based on cumulative data of the auxiliary usage data of the first battery pack; and select the second battery pack based on the first average power amount and a second average power amount supplied to an installation site of the ESS on average by the multiple battery packs.

According to some embodiments, the ESS management apparatus is configured to: calculate recommendation scores for the remaining battery packs based on states of health thereof, the first average power amount, and the second average power amount; and select the second battery pack based on the recommendation scores.

According to some embodiments, the ESS management apparatus is configured to: calculate a first suitability score, which indicates how suitable each of the remaining battery packs is for use in the vehicle, based on the remaining charge amounts of the remaining battery packs and the first average power amount; calculate a second suitability score, which indicates how suitable each of the remaining battery packs is for use at the installation site of the ESS, based on the remaining charge amounts of the remaining battery packs and the second average power amount; and calculate a recommendation score for each of the remaining battery packs based on the state of health, the first suitability score, and the second suitability score of each of the remaining battery packs.

ADVANTAGEOUS EFFECTS

According to the embodiments disclosed herein, it is possible to provide an energy storage system (ESS) management apparatus, an ESS management method, and an ESS management system that enable the utilization of the power of an ESS in an electric vehicle.

The technical effects according to the embodiments disclosed herein are not limited to the above-mentioned effects, and other effects not mentioned above will be clearly understood by a person ordinarily skilled in the art according to the disclosure of this document.

**DESCRIPTION OF DRAWINGS**

The drawings attached herewith are merely illustrative of embodiments of the present disclosure, and take on the role of further facilitating the understanding of the technical idea of the present disclosure along with the descriptions herein. Thus, the present disclosure should not be construed as being limited to those illustrated in the drawings.

FIG. 1 illustrates elements constituting an ESS management system according to some embodiments.
FIG. 2 illustrates a structure in which multiple battery packs are used in the ESS management system according to some embodiments.
FIG. 3 illustrates elements constituting an ESS management apparatus according to some embodiments.
FIG. 4 illustrates a structure of a battery pack used in a home or vehicle in an ESS management system according to some embodiments.
FIG. 5 illustrates operation of a battery pack of an ESS in a vehicle according to some embodiments.
FIG. 6 illustrates a process of supplying power to an air conditioner after a battery pack of an ESS according to some embodiments is mounted on a vehicle.
FIG. 7 illustrates a process in which a battery pack is returned from a vehicle to an ESS according to some embodiments.
FIG. 8 illustrates steps constituting an ESS management method according to some embodiments.
FIG. 9 illustrates a step in which an ESS management apparatus according to some embodiments selects a second battery pack to replace a first battery pack.

In some of the accompanying drawings, corresponding components are given the same reference numerals. A person ordinarily skilled in the art will appreciate that the drawings illustrate elements simply and clearly and are not necessarily drawn to scale. For example, in order to aid understanding of various embodiments, the dimensions of some elements illustrated in the drawings may be exaggerated compared to other elements. In addition, elements that are useful or essential in commercially implementable embodiments but are known in the art may often not be described in order to avoid impeding the understanding of the spirit of various embodiments of the present disclosure.

## MODE FOR INVENTION

Hereinafter, embodiments described in this document are described with reference to the attached drawings. However, this is not intended to limit the disclosure of this document to specific embodiments, and should be understood to include various modifications, equivalents, and/or alternatives to the embodiments described in this document.

The embodiments of this document and the terms used herein are not intended to limit the technical features described in this document to specific embodiments, and should be understood to include various changes, equivalents, or substitutes for the embodiments. In connection with the description of the drawings, similar reference numbers may be used for similar or related components. The singular form of a noun corresponding to an item may include one or more of the above items unless the relevant context clearly indicates otherwise.

In this disclosure, each of phrases, such as "A or B," "at least one of A and B," "at least one of A or B," "A, B, or C," "at least one of A, B, and C, and "at least one of A, B, or C," may include one of the items listed together in the corresponding phrase or all possible combinations of the items. Terms such as "first," "second," "primary," "secondary," "A," "B," "(a)," and "(b)" may be used to distinguish one component from another, and do not limit the components in other respects (e.g., importance or order) unless specifically stated otherwise.

In the disclosure, when a certain (e.g., first) component is described as being "connected," "coupled," or "linked" to another (e.g., second) component, either functionally or communicatively, with or without these terms, it means that the certain component may be connected directly (e.g., by wired or wireless connections) or indirectly (e.g., via a third component) connected to the other component.

Methods according to various embodiments disclosed herein may be included in and provided as a computer program product. The computer program product may be traded as a product between a seller and a purchaser. The computer program product may be distributed in the form of a machine-readable storage medium (e.g., compact disc read only memory (CD-ROM)), or may be distributed (e.g., downloaded or uploaded) online through an application store or directly between two user devices. In the case of online distribution, at least part of the computer program product may be temporarily stored in or temporarily produced from a machine-readable storage medium such as a manufacturer's server, a server of an application store, or memory of a relay server.

According to the embodiments disclosed herein, each of the above-described components (e.g., module or program) may include a single entity or multiple entities, and some of the multiple entities may be distributed separately from other components. According to the embodiments disclosed herein, one or more of the above-described components or operations may be omitted, or one or more other components or operations may be added. Alternatively or additionally, multiple components (e.g., modules or programs) may be integrated into a single component. In such a case, an integrated component may perform one or more functions of each of the multiple components in the same or a similar manner as performed by the corresponding one of the multiple components before the integration. According to the embodiments disclosed herein, operations performed by a module, a program, or other components may be executed sequentially, in parallel, repetitively, or heuristically, one or more of the operations may be executed in a different order or omitted, or one or more other operations may be added.

The embodiments disclosed herein provide an energy storage system (ESS) management apparatus, an ESS management method, and an ESS management system that enable the utilization of power from an energy storage system (ESS) in electric vehicles.

For efficient power utilization, secondary batteries may be configured in the form of an ESS. A home ESS may store solar energy in battery packs configured with secondary batteries and may utilize the stored energy within the home, and in addition to home use, the ESS may also be utilized in offices or business purposes. Meanwhile, research is being conducted on measures to expand the ESS beyond limited spaces such as homes, and research is also being conducted on measures to expand the use of the ESS to mobility fields such as electric vehicles, where solutions to energy supply and demand issues related driving distance are continuously required.

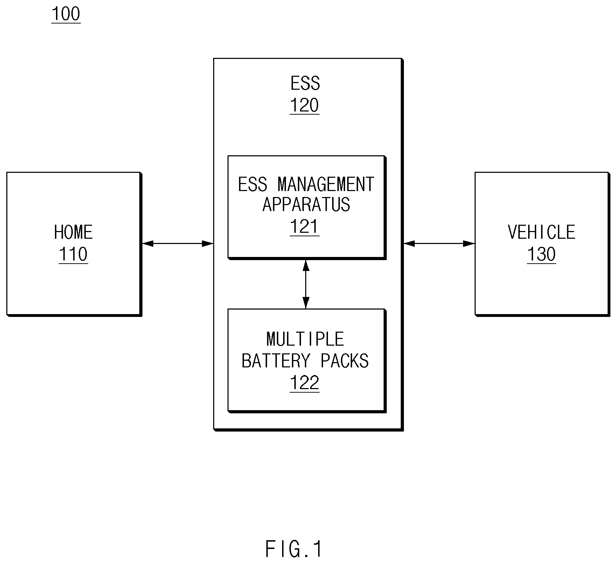

FIG. 1 illustrates elements constituting an ESS management system according to some embodiments of the present disclosure.

Referring to FIG. 1, the ESS management system 100 of the present disclosure may include an energy storage system (ESS) 120, and the ESS 120 may provide power, not only to a home 110, but also to a vehicle 130. According to an embodiment, the ESS 120 may include a home solar power device, and may be utilized not only in homes but also in offices, or for business purposes.

The ESS 120 may include an ESS management apparatus 121 and multiple battery packs 122. When the ESS 120 is a home ESS, electrical energy converted from sunlight may be used to charge the multiple battery packs 122, and the power of the multiple battery packs 122 may be utilized for various purposes in the home. For this purpose, the ESS management apparatus 121 may perform charging, discharging, and management functions of the multiple battery packs 122.

In the case of the home ESS, there may be a problem in that battery utilization is limited only to home use, and a measure to utilize the power of the multiple battery packs 122 outside the home may be needed. In this regard, power from the home ESS may be utilized in the electric vehicle.

The electric vehicle may use a main battery as a driving power source. Using a DC-DC converter, power from the main battery may be converted into control power, which may be used in a controller of the electric vehicle. The main battery of the electric vehicle is also used to drive air conditioning equipment such as the vehicle's heating and cooling devices. However, when using air conditioning functions such as heating and cooling devices, the driving range of the electric vehicle may be shortened as the capacity of the main battery is reduced, and since it is generally difficult to predict the usage of the air conditioning equipment, the accuracy of predicting the possible driving range of the electric vehicle may also decrease.

The ESS management system 100 may be configured to make the battery packs 122 of the home ESS 120 portable and mobile, thereby increasing its usability, and as a result, the use of the battery packs may be expanded, not only for home use, but also for, for example, air conditioning systems of electric vehicles. Using an ESS battery in an air conditioning system of an electric vehicle may solve, for example, the problem where a driver is reluctant to actively use the air conditioning system for fear of not being able to reach his/her destination because of insufficient capacity of the main battery for driving the electric vehicle.

The household ESS of the present disclosure may be equipped therein with multiple battery packs of the same type. According to an embodiment, each of the battery packs 122 may be mountable and removable, and may be charged and stored by the home ESS 120. While being removed and separated from the home ESS, each battery pack may exchange battery information with the ESS 120 from outside the ESS 120 using short-range communication methods such as Bluetooth. Each battery pack may have an acceleration sensor, may record an impact event when the event occurs, and may be able to self-diagnose related problems. For example, information such as the state of health (SOH), state of charge (SOC), and impact status of the battery pack may be transmitted to the ESS 120, and the ESS 120 may recommend the optimal battery pack for replacement through an algorithm.

The ESS management system 100 of the present disclosure is configured to use a home ESS battery as a power source for the air conditioning system of an electric vehicle. According to an embodiment, the main battery of the electric vehicle is selectively used for power and control purposes only, while the home ESS is used for driving the air conditioning system. With current technology, both driving and air conditioning systems of an electric vehicle are powered by the main battery, leading to a reduction in the electric vehicle's driving range when the air conditioning system is used. By utilizing the home ESS battery for the air conditioning system of the electric vehicle, the main battery may be used solely as a power source for driving. Consequently, the predictability of the driving range based on the main battery may be improved.

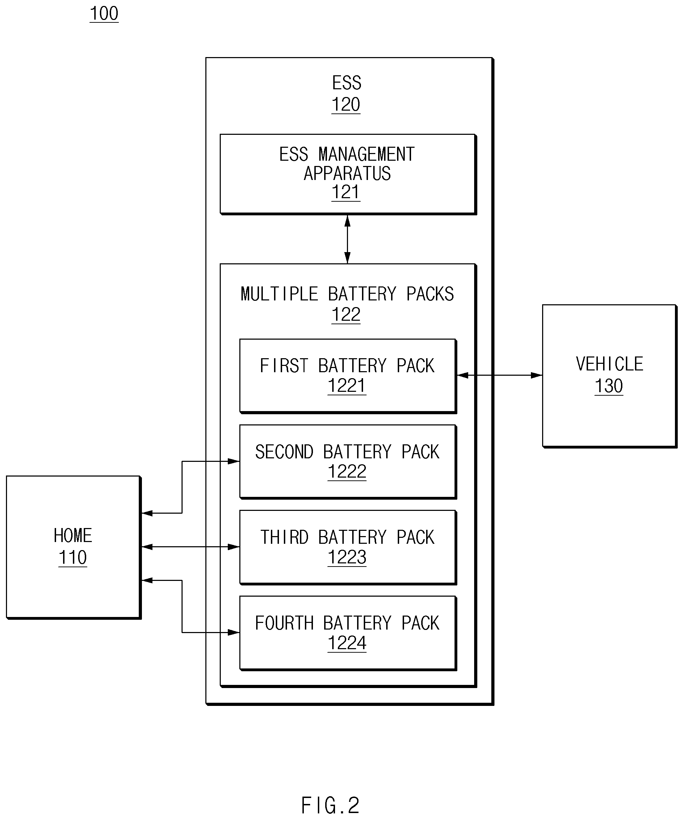

FIG. 2 illustrates a structure in which multiple battery packs 121 are used in an ESS management system 100 according to some embodiments.

Referring to FIG. 2, in the ESS management system 100 of the present disclosure, the multiple battery packs 122 may include four battery packs, including first to fourth battery packs 1221 to 1224. Meanwhile, unlike the example, the number of battery packs 122 may be less than 4 or 5, or more.

According to an embodiment, the first battery pack 1221 of the ESS 120 of the present disclosure is designed to supply power to the vehicle 130. For example, the first battery pack 1221 may be removed and separated from the ESS 120 and mounted on the vehicle 130, and may supply power to the air conditioner of the vehicle 130. The air conditioner of the vehicle 130 may perform, for example, heating, cooling, ventilation, and dehumidification functions. When the first battery pack 1221 of the ESS 120 is discharged in the vehicle 130, the user may separate the first battery pack 1221 from the vehicle 130 and return it to the ESS 120.

The second to fourth battery packs 1222 to 1224 may provide power to the outside of the ESS 120 according to the original function of the ESS 120. According to an embodiment, the ESS 120 may be a home ESS, and the second to fourth battery packs 1222 to 1224 may supply power to other electronic devices in the home where the ESS 120 is installed. When the first battery pack 1221 is returned, any one of the second to fourth battery packs 1222 to 1224 may be selected as the next battery pack by the ESS management apparatus 121 of the ESS 120, and the selected battery pack may be installed in the vehicle 130.

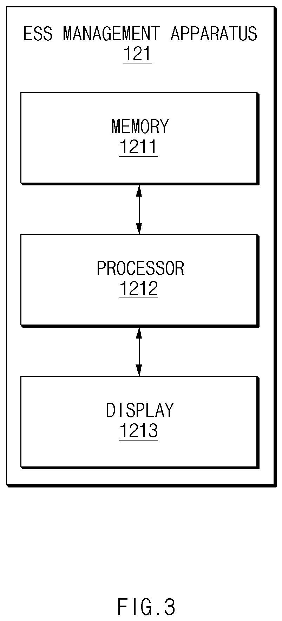

FIG. 3 illustrates elements constituting an ESS management apparatus according to some embodiments.

Referring to FIG. 3, the ESS management apparatus 121 may include a memory 1211 and a processor 1212. However, without being limited thereto, some components may be omitted from the ESS management apparatus 121, or other general-purpose components may be further included in the ESS management apparatus 121.

The memory 1211 and the processor 1212 may be operatively connected to each other. According to an embodiment, the memory 1211 and the processor 1212 may be electrically connected to each other through an inter-device communication scheme. According to an embodiment, the inter-device communication scheme may include, for example, a bus, a general purpose input and output (GPIO), a serial peripheral interface (SPI), and a mobile industry processor interface (MIPI).

The memory 1211 of the ESS management apparatus 121 may be configured to store, for example, various data, commands, software, mobile applications, and computer programs. For example, the memory 1211 may be implemented with a non-volatile device such as ROM, PROM, EPROM, EEPROM, flash memory, PRAM, MRAM, RRAM, or FRAM, or as a volatile device such as DRAM, SRAM, SDRAM, or PRAM, and may be implemented in the form of, for example, HDD, SSD, SD, or Micro-SD, or a combination thereof.

The processor 1212 of the ESS management apparatus 121 may implement operations of the ESS management apparatus 121 by executing instructions stored in the memory 1211. The processor 1212 may be implemented as an array of multiple logic gates or a general-purpose microprocessor for processing various operations, and may be configured with a single processor or multiple processors. For example, the processor 1212 may be implemented in the form of at least one of a microprocessor, CPU, GPU, and AP.

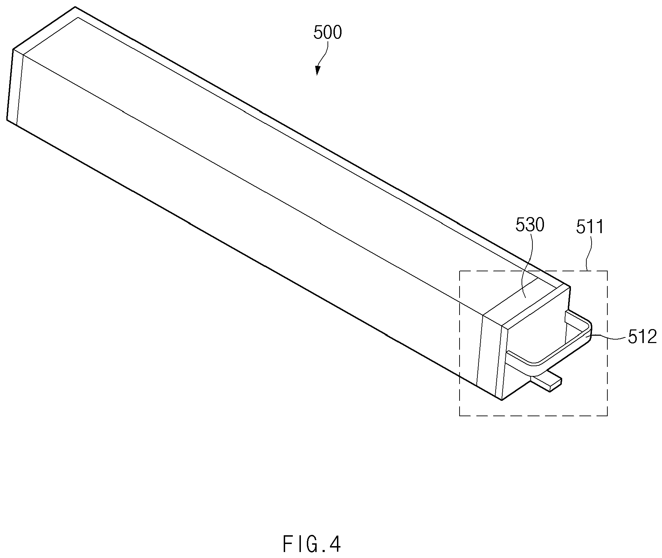

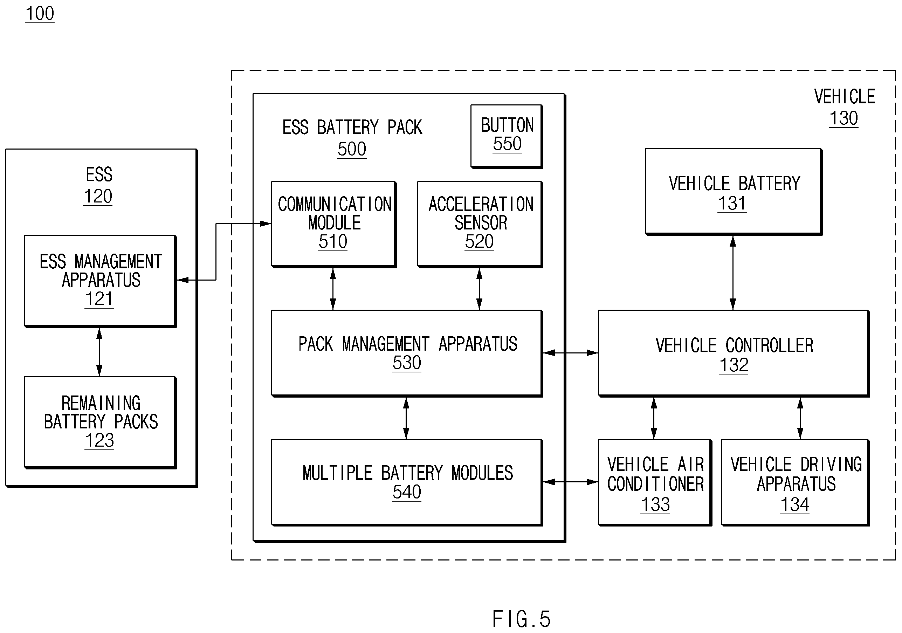

FIGS. 4 and 5 illustrate the structure and operation of an ESS battery pack 500 that supplies power to a home 110 or a vehicle 130 in an ESS management system 100 according to some embodiments of the present disclosure. According to an embodiment, the ESS battery pack 500 may correspond to each of the multiple battery packs 122.

The battery pack 500 may include multiple battery modules 540 installed inside the battery pack and a pack management apparatus 530 for managing the multiple battery modules 540. The pack management apparatus 530 may measure, for example, the voltage, current, and temperature, of each of the multiple battery modules 540 installed inside the battery pack, and based on these measurements, may perform management functions for the multiple battery modules 540. According to an embodiment, the pack management apparatus 530 may operate according to instructions from the ESS management apparatus 121.

The battery pack 500 is normally fixed to the ESS 120, and may be detached from the ESS 120 when necessary. The battery pack 500 that is detached and separated from the ESS 120 may be mounted on the vehicle 130. The battery pack 500 according to an embodiment may supply power to various electronic devices in the home 110 or other installation sites of the ESS 120. For this purpose, the battery pack can be carried or transported by the user. The front end 511 of the battery pack 500 may include a handle 512 to assist with mounting, detaching, and carrying of the battery pack 500.

Referring to FIG. 5, the vehicle 130 may include a vehicle battery 131, a vehicle controller 132, a vehicle air conditioner 133, and a vehicle driving apparatus 134. According to the embodiment, the ESS battery pack 500 may refer to the first battery pack 1221 mounted on the vehicle 130 among the multiple battery packs 122, and the remaining battery packs 123 may be charged and stored by the ESS 120.

According to an embodiment of the present disclosure, in the vehicle 130, the vehicle controller 132 may operate the vehicle air conditioner 133 and the vehicle driving apparatus 134 using power from the vehicle battery 131. Meanwhile, when the ESS battery pack 500 is mounted on the vehicle 130, the vehicle controller 132 may selectively operate the vehicle air conditioner 133 with the power of the ESS battery pack 500, and may operate, for example, the vehicle driving apparatus 134 of the vehicle 130, which is an electric vehicle, with the power of the vehicle battery 131.

According to an embodiment, the ESS battery pack 500 may include a communication module 510, an acceleration sensor 520, a pack management apparatus 530, and multiple battery modules 540. According to an embodiment, the communication module 510 may include a Bluetooth module for wireless communication with the ESS management apparatus 121. In addition, the acceleration sensor 520 of the ESS battery pack 500 may include a gyro sensor for recording an impact event of the vehicle 130. The pack management apparatus 530 may itself include a memory and a processor. The ESS battery pack 500 may further include a battery replacement button 550 for removal and separation (of the battery pack 500 from the vehicle 130).

Hereinafter, the operation of the ESS management system 100 of the present disclosure will be described, focusing on the operation of the ESS management apparatus 121.

Hereinafter, the operation of the ESS management system 100 of the present disclosure will be described

The processor 1212 of the ESS management apparatus 121 may be configured to acquire usage data to be used in the vehicle 130 (vehicle usage data) from the first battery pack 1221 among the multiple battery packs 122 of the energy storage system (ESS) 120. The vehicle usage data may include data regarding a power amount supplied to the vehicle 130 by the first battery pack. According to an embodiment, the vehicle usage data may include the usage of the first battery pack in the air conditioner of the vehicle 130.

The processor 1212 of the ESS management apparatus 121 may be configured to acquire charging state data of the battery packs other than the first battery pack 1221 among the multiple battery packs 122. According to an embodiment, the remaining battery packs may be charged using sunlight, and once charged, may be used to supply power to the home 110. The charging state data may include, for example, the current remaining charge level of each of the remaining battery packs, the amount of solar charging, and the amount of power supplied to the home 110.

The processor 1212 of the ESS management apparatus 121 may be configured to select a second battery pack 1222 to replace the first battery pack 1221 from among the remaining battery packs based on the vehicle usage data and charging state data. For example, based on the vehicle usage data and charging state data, the average power amount consumed by the air conditioner of the vehicle 130 and the average power amount supplied by the battery pack to the home 110 may be calculated, and based on these power amounts, the second battery pack 1222 may be selected to replace the first battery pack 1221.

According to an embodiment, the processor 1212 of the ESS management apparatus 121 may be configured to: form a communication channel with the pack management apparatus 530 of the ESS battery pack 500 (e.g., the first battery pack 1221) when entry into the replacement mode of the ESS battery pack 500 is detected; and acquire vehicle usage data from the pack management apparatus 530 via the communication channel. In the replacement mode, the vehicle usage data of the ESS battery pack 500 may be acquired, and the second battery pack 1222 may be selected to replace the ESS battery pack 500. The communication channel between the pack management apparatus 530 and the ESS management apparatus 121 may include, for example, a short-range communication channel such as Bluetooth. Since short-range wireless communication is possible, the user may prepare for battery pack replacement simply by moving the vehicle 130 to a location close to the ESS 120, without a need for a wired connection.

According to an embodiment, the processor 1212 of the ESS management apparatus 121 may be configured to enter the replacement mode when the battery replacement button 550, provided to remove the ESS battery pack 500 from the vehicle 130, is pressed by the user, or when the ESS battery pack 500 is separated from the vehicle 130. Each of the multiple battery packs 122 in the ESS 120 may be provided with a battery replacement button 550, which may be configured to release the fastening between the vehicle 130 and each battery pack. In this case, the battery pack replacement may be prepared by entering the replacement mode simultaneously with the release of the fastening. Alternatively, without pressing the button 550, the replacement mode may be initiated when the used ESS battery pack 500 is separated from the vehicle 130. In this way, the user's waiting time for battery pack replacement may be reduced.

According to an embodiment, the vehicle usage data may include auxiliary usage data regarding the amount of power used for auxiliary functions excluding the driving function of the vehicle 130 and acceleration data regarding an impact event of the vehicle 130. The auxiliary functions may include an air conditioning function for the interior of the vehicle 130, and the air conditioning function may include a cooling function, a heating function, a ventilation function, and a dehumidification function. The ESS battery pack 500 mounted on the vehicle 130 may supply power for the auxiliary functions, while the main battery of the vehicle 130 may supply power for the driving function. Accordingly, as the main battery in the electric vehicle is used for auxiliary functions, the reduction in driving range and the decrease in the accuracy of the estimated driving range of the vehicle 103, is, for example, prevented. According to an embodiment, the air conditioning function may have the largest power consumption among the auxiliary functions, and the ESS battery pack 500, for example, performs the power auxiliary function focusing on the air conditioning function.

Referring again to FIGS. 3 and 5, the processor 1212 of the ESS management apparatus 121 according to an embodiment may be further configured to: display the location where the second battery pack 1222 is stored in the ESS 120 on a display 1213 to inform the user; and diagnose whether there is an abnormality in the first battery pack 1221 based on acceleration data after the first battery pack 1221 is returned to the ESS 120. When the second battery pack 1222 is selected to replace the first battery pack 1221, the ESS management apparatus 121 may display the storage location of the second battery pack 1222 within the ESS 120 on the display 1213 to inform the user of the storage location. Subsequently, when the first battery pack 1221 is returned to the location where the second battery pack 1222 was accommodated, a diagnosis of the first battery pack 1221 may be performed, and it may be determined whether there is an abnormality caused by an impact event of the vehicle 130, based on acceleration data. For example, when an acceleration exceeding a reference value is detected, it may be diagnosed that damage to the battery pack is suspected due to an impact.

According to an embodiment, the processor 1212 of the ESS management apparatus 121 may be configured to: calculate a first average power amount (P_avg_car) to supplied to the vehicle 130 on average by the multiple battery packs 122 based on the cumulative data of the auxiliary usage data of the first battery pack 1221; and select the second battery pack 1222 based on the first average power amount (P_avg_car) and a second average power amount (P_avg_home) supplied to the installation site of the ESS 120 on average by the multiple battery packs 122. The ESS management apparatus 121 may analyze how suitable each of the remaining battery packs 123 is for replacement based on the first average power amount (P_avg_car) and the second average power amount (P_avg_home). The installation site of the ESS 120 may be the home 110, but may include an office or business space, without being limited thereto.

According to an embodiment, the processor 1212 of the ESS management apparatus 121 may be configured to: calculate recommendation scores (R_i) for each of the remaining battery packs 123 based on their state of health (SOH_i), the first average power amount (P_avg_car), and the second average power amount (P_avg_home); and select the second battery pack 1222 to be used as the ESS battery pack 500 from among the remaining battery packs 123 based on the recommendation scores (R_i). The state of health the i-th battery pack of the ESS 120 (SOH_i) may be calculated through an SOH estimation algorithm. The battery pack with the highest recommendation score (R_i) may be selected as the second battery pack 1222.

According to an embodiment, the processor 1212 of the ESS management apparatus 121 may be configured to calculate a first suitability score (N_car), which indicates how suitable each of the remaining battery packs 123 is for use in the vehicle 130, based on the state of charge (SOC_i) of the remaining battery packs 123 and the first average power amount (P_avg_car); calculate a second suitability score (N_home), which indicates how suitable each of the remaining battery packs 123 is for use at the installation site of the ESS 120 such as the home 110 based on the remaining charge amounts of the remaining battery packs 123 and the second average power amount (P_avg_home); and calculate the recommendation score (R_i) for each of the remaining battery packs 123, based on the state of health (SOH_i), the first suitability score (N_car), and the second suitability score (N_home) of each of the remaining battery packs 123. According to an embodiment, the recommendation score (R_i) for each of the remaining battery packs 123 may be calculated according to Equation 1.

[Equation 1]

$$R\_i = w1 * e^{-N\_car^2} + w2 * e^{-SOH\_i^2} + w3 * e^{-N\_home^2}$$

In Equation 1, the recommendation score (R_i) may be calculated based on the first suitability score (N_car), the state of health (SOH_i), and the second suitability score (N_home). To address the issue of decreasing values when using exponential functions, the first suitability score (N_car), the state of health (SOH_i), and the second suitability score (N_home) may be normalized. Weights (w1, w2, w3) may be applied to three normalized variables. Equations 2 to 4 may represent a specific method of normalization.

[Equation 2]

$$N\_car = \frac{E\_i - P\_avg\_car}{max\_N\_car - min\_N\_car}$$

[Equation 3]

$$N\_home = \frac{E\_left - P\_avg\_home}{max\_diff\_home - min\_diff\_home}$$

[Equation 4]

$$E\_left = E\_total - E\_i$$

In Equation 4, E_i may refer to the current remaining charge amount of the i-th battery pack. E_i may be calculated by multiplying the state of charge (SOC_i) by a conversion factor (C_i). E_total may refer to the total power amount of the remaining battery packs 123 in the ESS 120. In equation 3, E_left may refer to the power amount remaining in the ESS 120 when excluding the i-th battery pack. As the value of E_left - P_avg_home increases, the recommendation score (R_i) may also increase. In Equation 2, max_N_car may refer to the largest value among the values of E_i - P_avg_car of the remaining battery packs 123, and min_N_car may refer to the smallest value among the values of E_i - P_avg_car of the remaining battery packs 123.

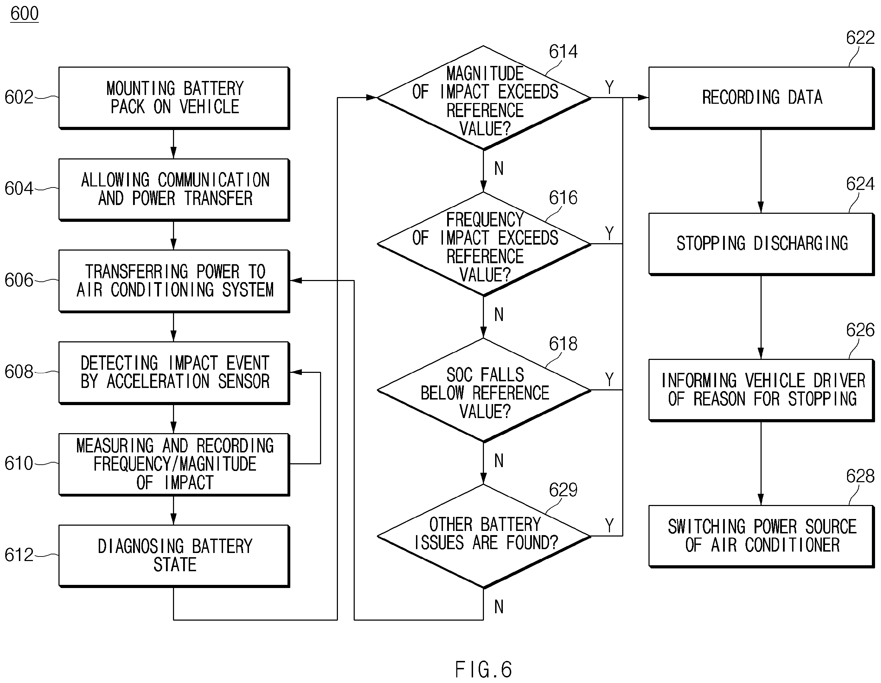

FIG. 6 illustrates a process of supplying power to an air conditioner after the ESS battery pack 500, according to some embodiments, is mounted on a vehicle.

Referring to FIG. 6, the process of supplying power to an air conditioner after the ESS battery pack 500 is mounted on the vehicle 130 (process 600) may include detailed steps including 602 through 628.

In step 602, the ESS battery pack 500 may be mounted on the vehicle 130, and in step 604, the controller 132 of the vehicle 130 may allow communication and power transfer with the ESS battery pack 500. In step 606, the ESS battery pack 500 may transfer power to the air conditioning system of the vehicle 130. When an impact event of the vehicle 130 occurs in step 608, the acceleration sensor 520 of the ESS battery pack 500 may operate. In step 610, the pack management apparatus 530 of the ESS battery pack 500 may record the frequency and magnitude of impacts applied to the ESS battery pack 500.

In step 612, the pack management apparatus 530 of the ESS battery pack 500 may diagnose the state of the ESS battery pack 500 in relation to the impact event. For example, the pack management apparatus 530 may identify whether the magnitude of the impact exceeds a reference value in step 614, identify whether the frequency of the impact exceeds a reference value in step 616, identify whether the state of charge (SOC) of the ESS battery pack 500 falls below the reference value in step 618, and identify whether other issues occur with the ESS battery pack 500 in step 620.

When the results of steps 614 to 620 are all "N" (NO), the ESS battery pack 500 may return to step 606 and continue to supply power to the vehicle 130. If any of the results of steps 614 to 620 are "Y" (YES), data regarding the impact event may be recorded in step 622, the vehicle container 132 of vehicle 130 may stop discharging of the ESS battery pack 500 in step 624, the vehicle controller 132 of the vehicle 130 may display the reason for stopping to a driver of the vehicle 130 in step 626, and the vehicle controller 132 of the vehicle 130 may operate the air conditioner with power from the vehicle battery 131, which is the main battery, in step 628.

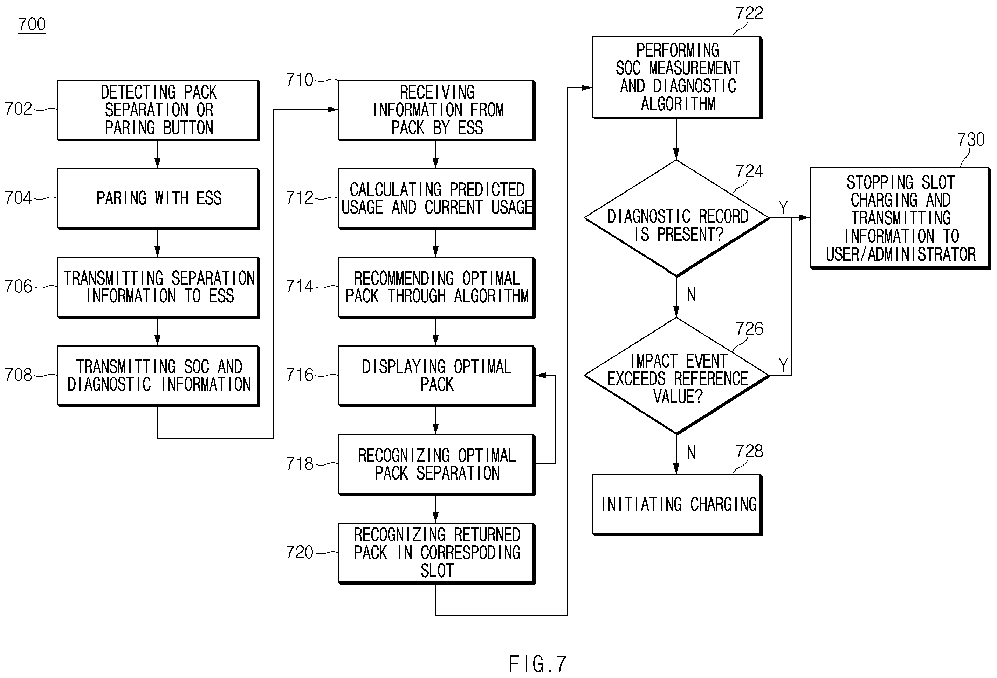

FIG. 7 illustrates a process in which the ESS battery pack 500 is returned from the vehicle 130 to the ESS 120 according to some embodiments.

Referring to FIG. 7, the process of returning the battery pack from the vehicle 130 to the ESS 120 (process 700) may include detailed steps including 702 through 730.

In step 702, the ESS management apparatus 121 of the ESS 120 may detect the separation of the ESS battery pack 500 or button input. In step 704, the ESS management apparatus 121 may be paired with the pack management apparatus 530 of the ESS battery pack 500. In step 706, the pack management apparatus 530 of the ESS battery pack 500 may transmit separation information, such as the remaining battery capacity and impact event logs, to the ESS management apparatus 121. In step 708, the pack management apparatus 530 may additionally transmit SOC information and diagnostic information to the ESS management apparatus 121.

In step 710, the ESS management apparatus 121 may receive information from the pack management apparatus 530. In step 712, the ESS management apparatus 121 may calculate the predicted usage and actual usage of a battery pack in the vehicle 130. In step 714, the ESS management apparatus 121 may recommend a battery pack to be replaced through an algorithm for selecting an optimal battery from among the remaining battery packs 123. In step 716, the ESS management apparatus 121 may display the accommodation location of the battery pack to be replaced to the user. In step 718, the ESS management apparatus 121 may recognize that the battery pack to be replaced is separated from the ESS 120. In step 720, the ESS management apparatus 121 can recognize that the battery pack, which was returned to the ESS 120 after being separated from the vehicle 130, is positioned at the position where the battery pack to be replaced was removed.

In step 722, the ESS management apparatus 121 may measure the SOC of the battery pack, which was separated from the vehicle 130 and returned to the ESS 120, and may perform a diagnostic algorithm for the returned battery pack. In step 724, the ESS management apparatus 121 may identify whether a diagnostic record by the pack management apparatus 530 exists for the returned battery pack. Then, in step 726, the ESS management apparatus 121 may identify whether the frequency and magnitude of impact on the returned battery pack exceed reference values. When the results of steps 724 and 726 are both "N" (NO), the ESS management apparatus 121 may initiate charging of the returned battery pack in step 728. When at least one of the results of steps 724 and 726 is "Y" (YES), the ESS management apparatus 121 may stop charging the slot where the returned battery pack is located, and provide the relevant information to the user and/or administrator.

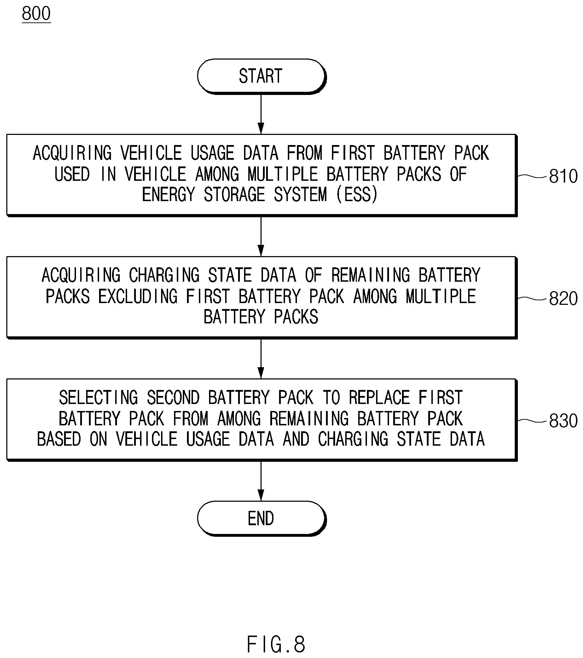

FIG. 8 illustrates steps constituting an ESS management method according to some embodiments of the present disclosure.

Referring to FIG. 8, the ESS management method 800 may include steps 810 to 830. However, without being limited thereto, some steps may be omitted, or other general-purpose steps may be added, and the steps of the ESS management method 800 may be executed in a different order from the illustrated order.

The ESS management method 800 may include steps processed in time series by the ESS management apparatus 121. Therefore, even when a description is omitted below, the descriptions above regarding the ESS management apparatus 121 may be equally applicable to the ESS management method 800.

According to an embodiment of the present disclosure, steps 810 to 830 of the ESS management method 800 may be performed by the memory 1211 and the processor 1212 of the ESS management apparatus 121.

In step 810, the ESS management apparatus 121 may acquire vehicle use data from a first battery pack 1221, which was used in the vehicle among the multiple battery packs 122 of the ESS 120.

In step 820, the ESS management apparatus 121 may acquire the charging state data of the remaining battery packs 123, excluding the first battery pack 1221, among the multiple battery packs 122.

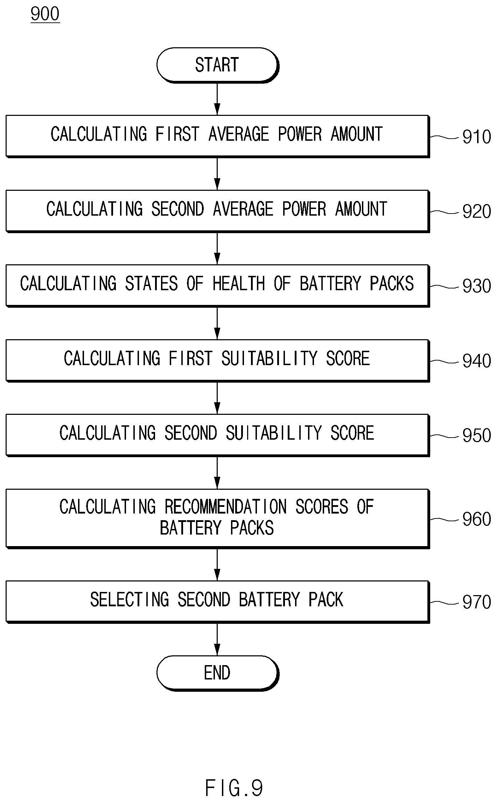

In step 830, the ESS management apparatus 121 may select a second battery pack 1222 to replace the first battery pack 1221 from among the remaining battery packs 123, based on vehicle usage data and charging state data. Referring to FIG. 9, according to an embodiment of the present disclosure, the ESS management apparatus 121 may perform the following steps to select the second battery pack 1222 to replace the first battery pack 1221 from among the remaining battery packs 123. However, these steps are not limited to this, some steps may be omitted, or other general-purpose steps may be added, and the steps of the ESS battery pack selection method 900 may be executed in a different order from the illustrated order.

First, in step 910, the ESS management apparatus 121 calculates the first average power amount supplied to the vehicle 130 on average by the multiple battery packs, based on the cumulative data of the auxiliary usage data of the first battery pack 1221, which was used in the vehicle 130.

In step 920, the ESS management apparatus 121 calculates the second average power amount supplied to the installation site of the ESS on average, by the multiple battery packs.

In step 930, the ESS management apparatus 121 calculates the states of health of the remaining battery packs 123 using, for example, an SOH estimation algorithm.

In step 940, the ESS management apparatus 121 calculates the first suitability score, which indicates how suitable each of the remaining battery packs 123 is for use in the vehicle 130, based on the remaining charge amounts of the remaining battery packs 123 and the first average power amount.

In step 950, the ESS management apparatus 121 calculates the second suitability score, which indicates how suitable each of the remaining battery packs 123 is for use at the installation site of the ESS, based on the remaining charge amounts of the remaining battery packs 123, and the second average power amount.

In step 960, the ESS management apparatus 121 calculates recommendation scores for the remaining battery packs 123 using the first suitability score, the second suitability score, and the states of health.

In step 970, the ESS management apparatus 121 selects a battery pack with the highest recommendation score as a second battery pack 1222, to replace the first battery pack 1221.

According to an embodiment of the present disclosure, the ESS management method 800 and the battery pack selection method 900 may be implemented in the form of a computer program stored in a computer-readable storage medium. That is, the computer program may include instructions for implementing the ESS management method 800 and the battery management method 900, and the instructions of the program may be stored in a computer-readable storage medium. The computer program may include a mobile application.

According to an embodiment, the computer-readable storage medium may include a magnetic medium such as a hard disk, a floppy disk, or a magnetic tape, an optical medium such as a CD-ROM or a DVD, a magneto-optical medium such as a floptical disk, and a hardware device specifically configured to store and execute computer program instructions, such as ROM, RAM, or flash memory. Computer program instructions may include machine language codes created by a compiler and high-level language codes capable of being executed by a computer using, for example, an interpreter.

The terms such as "include," "comprise," or "have," as used above, mean that the corresponding component may be included unless specifically stated to the contrary. Therefore, these terms should not be interpreted as excluding other components, but rather as being able to further include other components. All terms, including technical or scientific terms, have the same meaning as generally understood by a person ordinarily skilled in the technical field to which the embodiments disclosed herein belong, unless otherwise defined. Commonly used terms, such as terms defined in dictionaries, should be interpreted as consistent with the contextual meaning of the relevant technology, and should not be interpreted in an idealized or overly formal sense unless explicitly defined herein.

The foregoing description is merely an exemplary explanation of the technical idea disclosed herein. A person ordinarily skilled in the technical field to which the embodiments disclosed herein belong will be able to make various modifications and variations without departing from the essential characteristics of the embodiments disclosed herein. Accordingly, the embodiments disclosed herein are not intended to limit the technical idea of the embodiments disclosed herein, but rather to explain them, and the scope of the technical idea disclosed herein is not limited by these embodiments. The scope of protection of the technical idea disclosed herein should be interpreted in accordance with the claims below, and all technical ideas within the scope equivalent to the protection scope shall be interpreted as being included in the scope of rights of the present disclosure.

DESCRIPTION OF REFERENCE NUMERALS

| | | | |
|---|---|---|---|
| 100: | ESS management system | 110: | home |
| 120: | ESS | 121: | ESS management apparatus |
| 1211: | memory | 1212: | processor |
| 122: | multiple battery packs | 1221: | first battery pack |
| 123: | remaining battery packs | 130: | vehicle |

**Claims**

1. An ESS management apparatus comprising:

   a memory; and
   a processor operatively connected to the memory,
   wherein the processor is configured to:

   acquire vehicle usage data from a first battery pack used in a vehicle among multiple battery packs of an energy storage system (ESS);
   acquire charging state data of remaining battery packs excluding the first battery pack among the multiple battery packs; and
   select a second battery pack to replace the first battery pack from among the remaining battery packs based on the vehicle usage data and the charging state data.

2. The ESS management apparatus of claim 1, wherein the processor is further configured to:

   form a communication channel with a first pack management apparatus of the first battery pack when entry into a replacement mode of the first battery pack is detected; and
   acquire the vehicle usage data from the first pack management apparatus through the communication channel.

3. The ESS management apparatus of claim 2, wherein the processor is further configured to:
   enter the replacement mode when a battery replacement button provided to remove the first battery pack from the vehicle is pressed by a user or the first battery pack is separated from the vehicle.

4. The ESS management apparatus of claim 1, wherein the vehicle usage data includes auxiliary usage data regarding an amount of power used by the first battery pack for auxiliary functions other than a driving function of the vehicle, and acceleration data regarding an impact event of the first battery pack in the vehicle, and
   wherein the auxiliary functions include an air conditioning function for an interior of the vehicle, and the air conditioning function includes a cooling function, a heating function, a ventilation function, and a dehumidification function.

5. The ESS management apparatus of claim 4, wherein the processor is further configured to:

   display a location where the second battery pack is accommodated in the ESS on a display to inform the user of the location; and
   diagnose whether there is an abnormality in the first battery pack based on the acceleration data after the first battery pack is returned to the ESS.

6. The ESS management apparatus of claim 4, wherein the processor is further configured to:

   calculate a first average power amount supplied to the vehicle on average by the multiple battery packs based on cumulative data of the auxiliary usage data of the first battery pack used in the vehicle; and
   select the second battery pack based on the first average power amount and a second average power amount supplied to an installation site of the ESS on average by the multiple battery packs.

7. The ESS management apparatus of claim 6, wherein the processor is further configured to:

   calculate recommendation scores for the remaining battery packs based on states of health thereof, the first average power amount, and the second average power amount; and
   select the second battery pack from among the remaining battery packs based on the recommendation scores.

8. The ESS management apparatus of claim 7, wherein the processor is further configured to:

   calculate a first suitability score, which indicates how suitable each of the remaining battery packs is for use in the vehicle, based on the remaining charge amounts of the remaining battery packs and the first average power amount;
   calculate a second suitability score, which indicates how suitable each of the remaining battery packs is for use at the installation site of the ESS, based on the remaining charge amounts of the remaining battery packs and the second average power amount; and
calculate a recommendation score for each of the remaining battery packs based on the state of health, the first suitability score, and the second suitability score of each of the remaining battery packs.

9. An ESS management method comprising:

acquiring vehicle usage data from a first battery pack used in a vehicle among multiple battery packs of an energy storage system (ESS);
acquiring charging state data of remaining battery packs excluding the first battery pack among the multiple battery packs; and
selecting a second battery pack to replace the first battery pack from among the remaining battery packs based on the vehicle usage data and the charging state data.

10. The ESS management method of claim 9, wherein the acquiring the vehicle usage data includes:

forming a communication channel with a first pack management apparatus of the first battery pack when entry into a replacement mode of the first battery pack is detected; and
acquiring the vehicle usage data from the first pack management apparatus through the communication channel.

11. The ESS management method of claim 10, wherein the forming the communication channel includes entering the replacement mode when a battery replacement button provided for removing the first battery pack from the vehicle is pressed by a user, or when the first battery pack is separated from the vehicle.

12. The ESS management method of claim 9, wherein the vehicle usage data includes auxiliary usage data regarding an amount of power used by the first battery pack for auxiliary functions other than a driving function of the vehicle, and acceleration data regarding an impact event of the first battery pack in the vehicle, and
wherein the auxiliary functions include an air conditioning function for an interior of the vehicle, and the air conditioning function includes a cooling function, a heating function, a ventilation function, and a dehumidification function.

13. The ESS management method of claim 12, further comprising:

displaying a location where the second battery pack is accommodated in the ESS on a display to inform the user of the location; and
diagnosing whether there is an abnormality in the first battery pack based on the acceleration data after the first battery pack is returned to the ESS.

14. The ESS management method of claim 12, wherein the selecting the second battery pack includes:

calculating a first average power amount supplied to the vehicle on average by the multiple battery packs based on cumulative data of the auxiliary usage data of the first battery pack in the vehicle; and
selecting the second battery pack based on the first average power amount and a second average power amount supplied to an installation site of the ESS on average by the multiple battery packs.

15. The ESS management method of claim 14, wherein the selecting the second battery pack includes:

calculating recommendation scores for the remaining battery packs based on states of health thereof, the first average power amount, and the second average power amount; and
selecting the second battery pack based on the recommendation scores.

16. The ESS management method of claim 15, wherein the calculating the recommendation scores includes:

calculating a first suitability score, which indicates how suitable each of the remaining battery packs is for use in the vehicle, based on the remaining charge amounts of the remaining battery packs and the first average power amount;
calculate a second suitability score, which indicates how suitable each of the remaining battery packs is for use at the installation site of the ESS, based on the remaining charge amounts of the remaining battery packs and the second average power amount; and
calculating a recommendation score for each of the remaining battery packs based on the state of health, the first

suitability score, and the second suitability score of each of the remaining battery packs.

17. An ESS management system comprising:

multiple battery packs in an energy storage system (ESS); and
an ESS management apparatus,
wherein the ESS management apparatus is configured to:

acquire vehicle usage data from a first battery pack used in the vehicle among the multiple battery packs;
acquire charging state data of remaining battery packs excluding the first battery pack among the multiple battery packs; and
select a second battery pack to replace the first battery pack from among the remaining battery packs based on the vehicle usage data and the charging state data.

18. The ESS management system of claim 17, wherein the vehicle usage data includes auxiliary usage data regarding an amount of power used for auxiliary functions other than a driving function of the vehicle and acceleration data regarding an impact event of the vehicle, and
wherein the auxiliary functions include an air conditioning function for an interior of the vehicle, and the air conditioning function includes a cooling function, a heating function, a ventilation function, and a dehumidification function.

19. The ESS management system of claim 18,
wherein the ESS management apparatus is further configured to:

calculate a first average power amount supplied to the vehicle on average by the multiple battery packs based on cumulative data of the auxiliary usage data of the first battery pack; and
select the second battery pack based on the first average power amount and a second average power amount supplied to an installation site of the ESS on average by the multiple battery packs.

20. The ESS management system of claim 19, wherein the ESS management apparatus is further configured to:

calculate recommendation scores for the remaining battery packs based on states of health thereof, the first average power amount, and the second average power amount; and
select the second battery pack based on the recommendation scores.

100

ESS
120

ESS MANAGEMENT
APPARATUS
121

HOME
110

VEHICLE
130

MULTIPLE
BATTERY PACKS
122

FIG.1

100

ESS
120

ESS MANAGEMENT
APPARATUS
121

MULTIPLE BATTERY PACKS
122

FIRST BATTERY PACK
1221

SECOND BATTERY PACK
1222

THIRD BATTERY PACK
1223

FOURTH BATTERY PACK
1224

VEHICLE
130

HOME
110

FIG.2

ESS MANAGEMENT APPARATUS
121

MEMORY
1211

PROCESSOR
1212

DISPLAY
1213

FIG.3

FIG.4

FIG.5

EP 4 748 629 A1

600

```
┌─────────────────┐
│ MOUNTING BATTERY│
602 ─┤ PACK ON VEHICLE │
└─────────────────┘
         │
         ▼
┌─────────────────┐
│ALLOWING COMMUNICATION│
604 ─┤ AND POWER TRANSFER │
└─────────────────┘
         │
         ▼
┌─────────────────┐
│ TRANSFERRING POWER TO│
606 ─┤ AIR CONDITIONING SYSTEM │
└─────────────────┘
         │
         ▼
┌─────────────────┐
│ DETECTING IMPACT EVENT│
608 ─┤ BY ACCELERATION SENSOR │
└─────────────────┘
         │
         ▼
┌─────────────────┐
│MEASURING AND RECORDING│
610 ─┤ FREQUENCY/MAGNITUDE │
│ OF IMPACT │
└─────────────────┘
         │
         ▼
┌─────────────────┐
│ DIAGNOSING BATTERY│
612 ─┤ STATE │
└─────────────────┘
```

614 — MAGNITUDE OF IMPACT EXCEEDS REFERENCE VALUE? — Y → 622 RECORDING DATA

N

616 — FREQUENCY OF IMPACT EXCEEDS REFERENCE VALUE? — Y → 624 STOPPING DISCHARGING

N

618 — SOC FALLS BELOW REFERENCE VALUE? — Y → 626 INFORMING VEHICLE DRIVER OF REASON FOR STOPPING

N

629 — OTHER BATTERY ISSUES ARE FOUND? — Y → 628 SWITCHING POWER SOURCE OF AIR CONDITIONER

N

FIG.6

700

| 702 | DETECTING PACK SEPARATION OR PARING BUTTON |

| 704 | PARING WITH ESS |

| 706 | TRANSMITTING SEPARATION INFORMATION TO ESS |

| 708 | TRANSMITTING SOC AND DIAGNOSTIC INFORMATION |

| 710 | RECEIVING INFORMATION FROM PACK BY ESS |

| 712 | CALCULATING PREDICTED USAGE AND CURRENT USAGE |

| 714 | RECOMMENDING OPTIMAL PACK THROUGH ALGORITHM |

| 716 | DISPLAYING OPTIMAL PACK |

| 718 | RECOGNIZING OPTIMAL PACK SEPARATION |

| 720 | RECOGNIZING RETURNED PACK IN CORRESPODING SLOT |

| 722 | PERFORMING SOC MEASUREMENT AND DIAGNOSTIC ALGORITHM |

| 724 | DIAGNOSTIC RECORD IS PRESENT? |

| 726 | IMPACT EVENT EXCEEDS REFERENCE VALUE? |

| 728 | INITIATING CHARGING |

| 730 | STOPPING SLOT CHARGING AND TRANSMITTING INFORMATION TO USER/ADMINISTRATOR |

FIG.7

800

START

ACQUIRING VEHICLE USAGE DATA FROM FIRST BATTERY PACK USED IN VEHICLE AMONG MULTIPLE BATTERY PACKS OF ENERGY STORAGE SYSTEM (ESS) ~810

ACQUIRING CHARGING STATE DATA OF REMAINING BATTERY PACKS EXCLUDING FIRST BATTERY PACK AMONG MULTIPLE BATTERY PACKS ~820

SELECTING SECOND BATTERY PACK TO REPLACE FIRST BATTERY PACK FROM AMONG REMAINING BATTERY PACK BASED ON VEHICLE USAGE DATA AND CHARGING STATE DATA ~830

END

FIG.8

900

```
                    ┌─────────────┐
                    │    START    │
                    └──────┬──────┘
                           │
                           ▼
        ┌──────────────────────────────────────┐
        │  CALCULATING FIRST AVERAGE POWER AMOUNT│──── 910
        └──────────────────┬───────────────────┘
                           │
                           ▼
        ┌──────────────────────────────────────┐
        │  CALCULATING SECOND AVERAGE POWER AMOUNT│──── 920
        └──────────────────┬───────────────────┘
                           │
                           ▼
        ┌──────────────────────────────────────┐
        │ CALCULATING STATES OF HEALTH OF BATTERY PACKS│──── 930
        └──────────────────┬───────────────────┘
                           │
                           ▼
        ┌──────────────────────────────────────┐
        │   CALCULATING FIRST SUITABILITY SCORE │──── 940
        └──────────────────┬───────────────────┘
                           │
                           ▼
        ┌──────────────────────────────────────┐
        │  CALCULATING SECOND SUITABILITY SCORE │──── 950
        └──────────────────┬───────────────────┘
                           │
                           ▼
        ┌──────────────────────────────────────┐
        │    CALCULATING RECOMMENDATION SCORES OF│──── 960
        │              BATTERY PACKS            │
        └──────────────────┬───────────────────┘
                           │
                           ▼
        ┌──────────────────────────────────────┐
        │      SELECTING SECOND BATTERY PACK    │──── 970
        └──────────────────┬───────────────────┘
                           │
                           ▼
                    ┌─────────────┐
                    │     END     │
                    └─────────────┘
```

FIG.9

## INTERNATIONAL SEARCH REPORT

International application No.

**PCT/KR2024/010059**

### A. CLASSIFICATION OF SUBJECT MATTER

**B60L 53/60**(2019.01)i; **B60L 53/80**(2019.01)i; **B60L 53/53**(2019.01)i; **B60L 3/12**(2006.01)i; **H02J 7/34**(2006.01)i; **H02J 7/00**(2006.01)i; **H02J 7/14**(2006.01)i

According to International Patent Classification (IPC) or to both national classification and IPC

### B. FIELDS SEARCHED

Minimum documentation searched (classification system followed by classification symbols)

B60L 53/60(2019.01); B60L 11/18(2006.01); B60L 53/30(2019.01); B60L 58/10(2019.01); B60R 16/04(2006.01); H01M 10/48(2006.01); H01M 50/249(2021.01); H01M 50/269(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 에너지 저장장치(energy storage system), 배터리(battery), 충전(charging), 차량(vehicle), 교체(change)

### C. DOCUMENTS CONSIDERED TO BE RELEVANT

| Category* | Citation of document, with indication, where appropriate, of the relevant passages | Relevant to claim No. |
|---|---|---|
| Y | KR 10-1682788 B1 (INDUSTRIAL BANK OF KOREA) 12 December 2016 (2016-12-12)<br>See paragraphs [0041]-[0083]; and figure 1. | 1-20 |
| Y | KR 10-2015-0064378 A (KANG, Byung Hyouk) 11 June 2015 (2015-06-11)<br>See paragraphs [0037]-[0049]; and figure 2. | 1-20 |
| Y | KR 10-2022-0121932 A (E-MOTION CO., LTD.) 02 September 2022 (2022-09-02)<br>See paragraph [0058]. | 4-8,12-16,18-20 |
| A | KR 10-2021-0033647 A (IDP CO., LTD. et al.) 29 March 2021 (2021-03-29)<br>See paragraph [0039]. | 1-20 |
| A | KR 10-2515020 B1 (RODDY, Daniel Francis et al.) 30 March 2023 (2023-03-30)<br>See paragraphs [0020]-[0038]; and figure 12. | 1-20 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 October 2024** | **21 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/010059**

| Patent document cited in search report | | | Publication date (day/month/year) | Patent family member(s) | | | Publication date (day/month/year) |
|---|---|---|---|---|---|---|---|
| KR | 10-1682788 | B1 | 12 December 2016 | KR | 10-2016-0092733 | A | 05 August 2016 |
| KR | 10-2015-0064378 | A | 11 June 2015 | CN | 105939886 | A | 14 September 2016 |
| | | | | CN | 105939886 | B | 14 August 2018 |
| | | | | KR | 10-1542664 | B1 | 12 August 2015 |
| | | | | US | 2016-0303988 | A1 | 20 October 2016 |
| | | | | US | 9994115 | B2 | 12 June 2018 |
| | | | | WO | 2015-083898 | A1 | 11 June 2015 |
| KR | 10-2022-0121932 | A | 02 September 2022 | | None | | |
| KR | 10-2021-0033647 | A | 29 March 2021 | KR | 10-2242968 | B1 | 21 April 2021 |
| KR | 10-2515020 | B1 | 30 March 2023 | CA | 3103901 | A1 | 09 January 2020 |
| | | | | CN | 112585026 | A | 30 March 2021 |
| | | | | CN | 112585026 | B | 16 January 2024 |
| | | | | CN | 117549768 | A | 13 February 2024 |
| | | | | EP | 3817945 | A1 | 12 May 2021 |
| | | | | JP | 2021-530088 | A | 04 November 2021 |
| | | | | JP | 7483637 | B2 | 15 May 2024 |
| | | | | KR | 10-2023-0047199 | A | 06 April 2023 |
| | | | | KR | 10-2622402 | B1 | 08 January 2024 |
| | | | | MX | 2020014010 | A | 25 March 2021 |
| | | | | TW | 202015278 | A | 16 April 2020 |
| | | | | TW | I722453 | B | 21 March 2021 |
| | | | | US | 10355254 | B1 | 16 July 2019 |
| | | | | US | 10446809 | B1 | 15 October 2019 |
| | | | | US | 10573859 | B2 | 25 February 2020 |
| | | | | US | 10720614 | B2 | 21 July 2020 |
| | | | | US | 11069938 | B2 | 20 July 2021 |
| | | | | US | 11695184 | B2 | 04 July 2023 |
| | | | | US | 2020-0014000 | A1 | 09 January 2020 |
| | | | | US | 2020-0106063 | A1 | 02 April 2020 |
| | | | | US | 2020-0321568 | A1 | 08 October 2020 |
| | | | | US | 2022-0069406 | A1 | 03 March 2022 |
| | | | | US | 2023-0395923 | A1 | 07 December 2023 |
| | | | | WO | 2020-009817 | A1 | 09 January 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230117274

- KR 1020240088443